(19)

(11) EP 2 201 689 B1

(12) **FASCICULE DE BREVET EUROPEEN**

(45) Date de publication et mention de la délivrance du brevet: **29.02.2012 Bulletin 2012/09**

(21) Numéro de dépôt: **08841432.1**

(22) Date de dépôt: **07.10.2008**

(51) Int Cl.: ***H03M 1/34*** *(2006.01)* ***H03M 1/12*** *(2006.01)*

(86) Numéro de dépôt international: **PCT/FR2008/051813**

(87) Numéro de publication internationale: **WO 2009/053607 (30.04.2009 Gazette 2009/18)**

(54) **QUANTIFICATEUR, CONVERTISSEUR ANALOGIQUE-NUMERIQUE COMPRENANT UN TEL QUANTIFICATEUR, ET RECEPTEUR ULTRA-LARGE BANDE INTEGRANT UN TEL CONVERTISSEUR**

QUANTISIERER, ANALOG-DIGITAL-UMSETZER MIT EINEM SOLCHEN QUANTISIERER UND EINEN SOLCHEN UMSETZER INTEGRIERENDER ULTRABREITBANDEMPFÄNGER

QUANTIZER, ANALOGUE-DIGITAL CONVERTER COMPRISING SUCH A QUANTIZER, AND ULTRA-WIDEBAND RECEIVER INTEGRATING SUCH A CONVERTER

(84) Etats contractants désignés: **AT BE BG CH CY CZ DE DK EE ES FI FR GB GR HR HU IE IS IT LI LT LU LV MC MT NL NO PL PT RO SE SI SK TR**

(30) Priorité: **12.10.2007 FR 0758284**

(43) Date de publication de la demande: **30.06.2010 Bulletin 2010/26**

(73) Titulaire: **Commissariat à l'Énergie Atomique et aux Énergies Alternatives 75015 Paris (FR)**

(72) Inventeur: **LACHARTRE, David F-38330 Montbonnot (FR)**

(74) Mandataire: **Vuillermoz, Bruno Cabinet Laurent & Charras "Le Contemporain" 50, Chemin de la Bruyère 69574 Dardilly Cédex (FR)**

(56) Documents cités: **US-A- 5 760 730**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).



Printed by Jouve, 75001 PARIS (FR)

## Description

## DOMAINE DE L'INVENTION

La présente invention a trait au domaine de la quantification de signaux analogiques, et plus particulièrement la quantification à haute vitesse de signaux analogiques.

La présente application trouve application notamment dans la réception de données transmises sous forme d'une onde radiofréquence, et particulièrement dans une réception du type ultra-large bande.

## ETAT ANTERIEUR DE LA TECHNIQUE

Certaines applications, comme par exemple la transmission de données par onde radiofréquence, nécessitent une conversion analogique-numérique à très haute vitesse pouvant atteindre plusieurs gigaéchantillons par seconde.

A cette fin, des convertisseurs analogiques-numériques, ou CAN, du type flash sont usuellement utilisés en raison de leur vitesse de conversion. Le principe d'un tel CAN consiste à comparer le signal à convertir à autant de tensions différentes qu'il y a de pas de conversion souhaités.

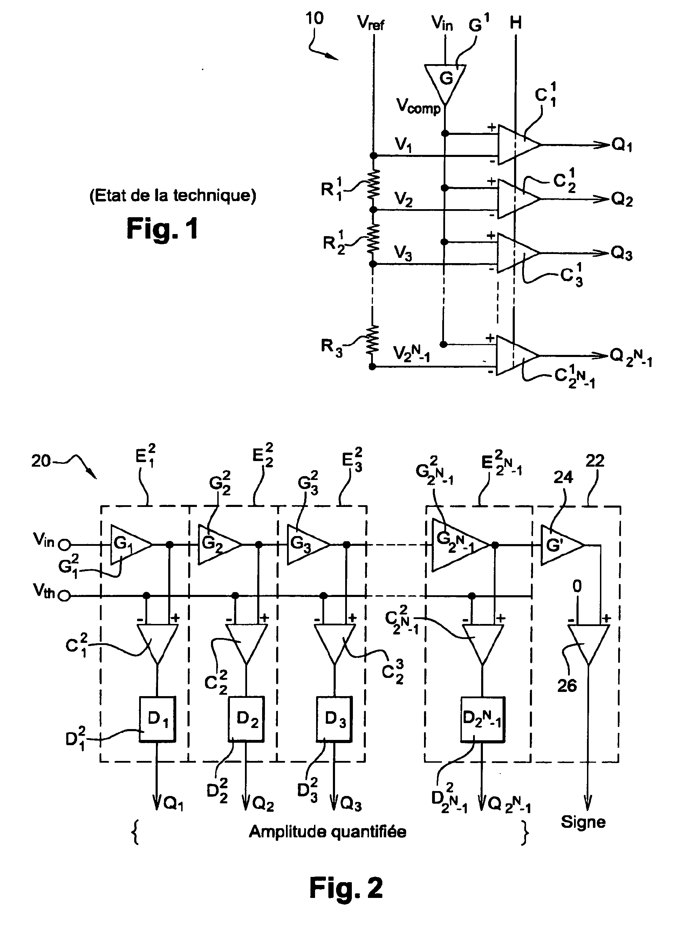

Un exemple de CAN flash à N bits est illustré schématiquement à la figure 1 sous la référence générale **10.** Ce CAN comprend $2^N$-1 comparateurs de tension $C_1^1, C_2^1, C_3^1, \ldots, C_{2^N-1}^1$, un amplificateur $\mathbf{G^1}$, et $2^N$-2 résistances $R_1^1, R_2^1, R_3^1, \ldots, R_{2^N-1}^1$ connectées en série entre une tension de référence $V_{ref}$ et la masse.

L'amplificateur de tension $\mathbf{G^1}$ reçoit en entrée et amplifie une tension $V_{in}$ à quantifier et à échantillonner, et est connecté en sortie à chacune des entrées positives (+) des comparateurs $C_1^1, C_2^1, C_3^1, \ldots, C_{2^N-1}^1$ à qui il délivre la tension amplifiée $V_{amp}$.

Les $2^N$-2 résistances $R_1^1, R_2^1, R_3^1, \ldots, R_{2^N-1}^1$ sont de valeur identique R et forment un pont diviseur de tension définissant $2^N$-2 tensions $V_2, V_3, \ldots, V_{2^N-1}$. Le premier comparateur $C_1^1$ a sa borne négative (-) connectée à la tension Vref et les autres comparateurs $C_2^1, C_3^1, \ldots, C_{2^N-1}^1$ ont leur borne négative (-) connectée respectivement aux tensions $V_2, V_3, \ldots, V_{2^N-1}$.

La tension amplifiée $V_{amp}$ attaque donc parallèlement et simultanément les comparateurs $C_1^1, C_2^1, C_3^1, \ldots, C_{2^N-1}^1$, et est ainsi comparée à $2^N$-1 tensions de seuil $V_1=V_{ref}, V_2, V_3, \ldots, V_{2^N-1}$. Les sorties des comparateurs $C_1^1, C_2^1, C_3^1, \ldots, C_{2^N-1}^1$ définissent de ce fait les valeurs binaires quantifiées $Q_1$, $Q_2$, $Q_3$, $Q_{2^N-1}$ du CAN flash.

Par ailleurs, les comparateurs $C_1^1, C_2^1, C_3^1, \ldots, C_{2^N-1}^1$ sont synchrones, c'est-à-dire qu'ils délivrent le résultat de leur comparaison sur les fronts montants ou descendants d'une horloge d'échantillonnage H.

Ainsi, le CAN flash quantifie le signal $V_{in}$ avec un pas de quantification constant tout en échantillonnant simultanément celui-ci à la fréquence du signal d'horloge H.

Du fait de l'agencement parallèle des comparateurs $C_1^1, C_2^1, C_3^1, \ldots, C_{2^N-1}^1$, de très hautes vitesses peuvent être atteintes. Usuellement la vitesse de conversion de ce type de convertisseur est limitée uniquement par la vitesse de fonctionnement des comparateurs.

Or, un CAN flash pose les problèmes suivants.

Tout d'abord, le signal $V_{in}$ nécessite d'être amplifié en amplitude pour utiliser au mieux la plage dynamique du CAN. Il existe ainsi une amplification biaisée au niveau de chaque comparateur. En effet, en considérant ce CAN linéaire, on peut considérer que l'amplification par l'amplificateur $\mathbf{G^1}$ est équivalente à une réduction, par le gain de l'amplificateur $\mathbf{G^1}$, de toutes les tensions de seuil $V_1, V_2, V_3, \ldots, V_{2^N-1}$. L'amplification du signal $V_{in}$ peut ainsi être vue comme comprise dans la fonction de comparaison elle-même, c'est-à-dire une comparaison incluant une amplification biaisée par la présence des tensions de seuil.

Ensuite, le signal à quantifier $V_{in}$ nécessite également d'être amplifié en puissance, afin de charger en parallèle les $2^N$-1 comparateurs $C_1^1, C_2^1, C_3^1, \ldots, C_{2^N-1}^1$. Ainsi pour un fonctionnement satisfaisant du CAN flash, l'amplificateur $\mathbf{C^1}$ doit donc être puissant, linéaire, et à faible bruit. De plus, dans le cas de faibles signaux pour $V_{in}$, une amplification importante doit être réalisée en un seul étage. L'ensemble de ces contraintes rend la conception de l'amplificateur $\mathbf{G^1}$ difficile et aboutit dans le meilleur de cas à un amplificateur grand consommateur d'énergie.

En outre, pour tenir la charge dans les comparateurs, il est souvent nécessaire, voire obligatoire, d'incorporer dans ceux-ci des buffers puissants. La consommation est ainsi encore accrue.

Le document US-A-S 760 730 divulgue un quantificateur synchrone comprenant des étages amplificateurs de signal agencés en série, l'entrée du premier étage étant apte à recevoir le signal à quantifier, et des comparateurs, un comparateur étant connecté à la sortie de chaque étage amplificateur et apte à comparer la valeur de cette sortie à une valeur de seuil prédéterminée. Selon ce document, les sorties des comparateurs sont fournies à un registre de verrouillage à bascules dont la sortie définit la valeur binaire quantifiée.

Le but de la présente invention est de résoudre les problèmes susmentionnés en proposant un quantificateur économe en énergie, qui autorise une quantification comparable à celle des CAN flash, notamment en ce qui concerne la rapidité de quantification.

## EXPOSE DE L'INVENTION

A cet effet l'invention a tout d'abord pour objet un quantificateur asynchrone à N bits comportant :

- ■ $2^N$-1 étages amplificateurs de signal agencés en série, l'entrée du premier étage étant apte à recevoir un signal à quantifier ; et
- ■ $2^N$-1 comparateurs, un comparateur étant connecté à la sortie de chaque étage amplificateur, et apte à comparer la valeur de cette sortie à une valeur de seuil prédéterminée ; et
- ■ au moins $2^N$-2 lignes à retard placées en sortie des $2^N$-2 premiers comparateurs, les sorties des lignes à retard et du dernier comparateur définissant les valeurs binaires quantifiées du quantificateur.

En d'autres termes, dans une telle architecture, une amplification est réalisée simultanément à la quantification et de manière graduelle.

Ainsi, pour obtenir l'amplification nécessaire à l'utilisation optimale de la dynamique du quantificateur, il peut être utilisé des amplificateurs dont les gains sont de l'ordre du gain de l'amplificateur du CAN flash divisé par $2^N$. De fait, ces amplificateurs sont de plus faible puissance, consomment ensemble moins que l'amplificateur utilisé dans le CAN flash, et présentent un comportement plus linéaire.

Par ailleurs, l'amplification étant simultanée à la quantification, il n'est pas nécessaire de prévoir une amplification en amont du quantificateur pour s'assurer que la dynamique du quantificateur est effectivement pleinement exploitée.

En outre, son gain peut être avantageusement choisi entre 1 et 2, sachant que des amplificateurs présentant un tel gain sont de conception simple et de consommation réduite.

De plus, une telle architecture est peu sensible aux non linéarités de ses composants électroniques. En effet, les non linéarités apparaissent lorsque les signaux auxquels ils sont soumis prennent des valeurs élevées. C'est par exemple le cas des phénomènes de saturation.

Or, dans le cas où la sortie d'un étage dépasse le seuil qui lui est associé, on sait que les seuils des comparateurs suivants seront également dépassés en raison de l'amplification réalisée par les étages consécutifs. Les non-linéarités des amplificateurs suivants n'a ainsi aucune incidence sur la quantification puisque la quantification mise en oeuvre par une telle architecture débute par le bit de poids fort, associé au premier étage amplificateur, et termine par le bit de poids faible, associé au dernier étage amplificateur. Ceci est d'autant plus intéressant lorsque le signal à quantifier prend une valeur supérieure au premier seuil, car l'ensemble des non linéarités des composants suivants dans la chaîne n'ont aucune incidence sur la quantification. De fait, il est seulement nécessaire qu'un amplificateur soit linéaire jusqu'à la valeur de seuil qui lui est associée.

Selon des modes de réalisation particuliers de l'invention, le quantificateur comprend une ou plusieurs des caractéristiques suivantes.

La valeur absolue du gain d'un étage amplificateur est comprise entre environ 1 et environ 2. Ainsi, il est utilisé des amplificateurs de faible gain peu consommateurs d'énergie, et simples à concevoir.

Les gains des étages amplificateurs sont sensiblement identiques. Dans un tel cas, une quantification avec compression logarithmique est obtenue, ce qui est avantageux dans le cas des signaux présentant une grande dynamique.

La valeur absolue du gain d'un étage amplificateur, hormis le premier, est sensiblement égal à i/(i-1) *G1, où G1 est le gain du premier étage amplificateur et i la position de l'étage amplificateur dans la série d'étages amplificateurs. Il est ainsi obtenu une quantification avec des amplitudes à pas constant entre deux étages amplificateurs consécutifs. On retrouve ainsi la quantification usuellement mise en oeuvre dans les CAN flash.

Le gain des étages amplificateurs est négatif. De cette manière, il est possible de réaliser, simultanément à la quantification, un redressement du signal à quantifier. En outre, on peut utiliser des inverseurs, qui sont des composants simples à concevoir et peu consommateurs d'énergie.

Un étage amplificateur est également agencé pour filtrer la composante continue du signal à quantifier. Ceci est notamment utile dans le cas où le signal à quantifier présente en théorie une composante continue nulle. Ainsi, il est réalisé un filtrage d'un décalage continu parasite. Ceci est par exemple réalisé au moyen du gain de l'étage amplificateur qui est choisi pour être sensiblement nul aux basses fréquences.

Chaque étage amplificateur est du type à contrôle de gain automatique. De cette manière, on s'assure que la quantification se fait sur toute la dynamique du signal $V_{in}$. Ceci est particulièrement intéressant dans le cas d'une réception RF pour s'adapter à la puissance du signal reçu.

Chaque étage amplificateur comporte :

- ■ un amplificateur différentiel, dont une entrée positive forme l'entrée de l'étage amplificateur ;
- ■ une première impédance, connectée entre une entrée négative et une sortie de l'amplificateur différentiel ; et
- ■ une seconde impédance, connectée entre l'entrée négative de l'amplificateur différentielle et une masse.

Chaque étage amplificateur comporte un agencement série de deux cellules amplificatrices, chacune de ces cellules étant composée :

- ■ d'un inverseur, dont la sortie forme la sortie de la cellule,
- ■ d'une première impédance connectée entre l'entrée et la sortie de l'inverseur, et
- ■ d'une seconde impédance connectée à l'une de ses bornes à l'entrée de l'inverseur, et dont l'autre borne forme l'entrée de la cellule.

Il est ainsi possible de façonner la réponse fréquentielle du gain par un choix approprié de la valeur des impédances. Par exemple, il peut être conçu des gains à bande étroite du type passe-bande accordé avec le signal à quantifier.

L'étage amplificateur peut comporter :

- ■ un inverseur, dont la sortie forme la sortie de l'étage amplificateur,
- ■ une première impédance connectée entre l'entrée et la sortie de l'inverseur, et
- ■ une seconde impédance connectée à l'une de ses bornes à l'entrée de l'inverseur, et dont l'autre borne forme l'entrée de l'étage.

De cette manière, il est obtenu une quantification entrelacée des alternances positives et négatives du signal à quantifier. On divise ainsi le nombre d'étages par deux en faisant la supposition que le signal reçu varie peu entre les alternances positives et négatives.

De préférence, dans le cas où le gain d'un étage amplificateur est négatif, le quantificateur comporte en outre un module de traitement numérique apte à appliquer une fonction « OU » à chaque paire de sorties consécutives des lignes à retard, le résultat de la fonction « OU » formant une valeur binaire quantifiée. Le quantificateur met ainsi en oeuvre simultanément une quantification et un redressement. En outre, le dernier étage fournit le signe du signal à quantifier.

De préférence, la valeur en continue de la seconde impédance est sensiblement supérieure à la valeur en continue de la première impédance, de manière à filtrer la composante continue et s'assurer qu'un décalage continu, par exemple introduit par les composantes du quantificateur, ne se propage pas le long de la chaîne d'amplification.

De préférence, la première impédance est celle définie entre le drain et la source d'un transistor MOS. Il est ainsi possible de commander simplement le gain de l'étage amplificateur par la commande de la tension appliquée à la grille du transistor MOS. Il est alors possible de prévoir des moyens de contrôle automatique du gain de l'étage amplificateur par une commande appropriée de cette tension de grille.

La valeur de seuil peut être unique pour l'ensemble des comparateurs. On peut ainsi choisir des comparateurs identiques pour le quantificateur et ainsi diminuer les risques de dispersion des caractéristiques des composants du quantificateur. En outre, à l'aide d'une tension de seuil unique de faible valeur, les propriétés de la quantification (dynamique de la quantification, compression logarithmique, à pas constant, etc...) sont principalement fixées par le choix des gains des étages amplificateurs

Chaque comparateur peut comporter :

- ■ un amplificateur différentiel à grand gain, recevant sur une entrée positive la sortie de l'étage amplificateur correspondant, et sur une entrée négative la valeur de seuil correspondante,
- ■ et un module de prise de décision binaire, connecté en sortie de l'amplificateur différentiel à grand gain.

De préférence, le module de prise de décision binaire comprend un discriminateur à hystérésis. De cette manière, les valeurs quantifiées sont correctement saturées.

Le quantificateur peut comporter en outre un module de filtrage connecté en sortie du module de prise de décision binaire pour éliminer des impulsions de durée inférieure à une durée prédéterminée. Ceci se traduit par une réduction du bruit ainsi qu'un meilleur comportement de la quantification aux hautes fréquences.

Le quantificateur comporte une ligne à retard connectée à la sortie de chaque comparateur, les lignes à retard étant agencées pour délivrer la sortie des comparateurs sensiblement au même instant. De préférence, chaque ligne à retard comporte $2^N$-1-i cellules à retard sensiblement identiques, où i est la position de l'étage amplificateur associé à la ligne dans la série d'étages amplificateurs.

De cette manière, les retards induits par la propagation du signal le long de la chaîne d'amplification sont compensés.

Le quantificateur peut également comporter, en début ou en fin de la série d'étages amplificateurs, un étage amplificateur supplémentaire, et un comparateur supplémentaire connecté à la sortie de l'étage amplificateur supplémentaire, et apte à comparer la sortie de celui-ci à la valeur nulle pour déterminer le signe du signal à quantifier.

La présente invention a également pour objet un convertisseur analogique-numérique à N bits comportant un quantificateur du type précité et un échantillonneur relié au quantificateur, et apte à échantillonner les signaux qu'il reçoit en entrée.

En d'autres termes, dans un tel convertisseur, la fonction de quantification est dissociée de la fonction d'échantillonnage, ce qui résulte de l'architecture du quantificateur qui est par nature asynchrone. Il est ainsi possible d'appliquer tout traitement numérique asynchrone jugé utile au signal quantifié avant son échantillonnage.

Ceci est particulièrement avantageux lorsque l'information utile contenue dans le signal quantifiée est contenue dans une gamme de fréquences basses, comme cela est généralement le cas de la réception de données radiofréquence modulées, pour lesquelles seule l'enveloppe du signal est utile. Avant l'échantillonnage, il est donc possible d'appliquer une extraction de l'enveloppe, par exemple au moyen d'un filtre passe-bas, puis d'échantillonner à une fréquence basse. Une économie d'énergie est ainsi obtenue puisqu'il n'est pas nécessaire de prévoir un échantillonneur haute vitesse très consommateur d'énergie.

Selon des modes de réalisation particuliers de l'invention, le convertisseur comporte une ou plusieurs des caractéristiques suivantes.

Le convertisseur peut comporter un module de traitement numérique connecté entre le quantificateur et l'échantillonneur.

L'invention a également pour objet un récepteur ultra-large bande comportant un convertisseur du type précité.

## BREVE DESCRIPTION DES FIGURES

L'invention sera mieux comprise à la lecture de la description qui suit, donnée uniquement à titre d'exemple, et réalisée en relation avec les dessins annexés, dans lesquels :

- la figure 1 est une vue schématique d'un CAN flash classique, dont il a déjà été discuté dans le préambule ;
- la figure 2 est une vue schématique d'un premier mode de réalisation du quantificateur selon l'invention ;
- les figures 3 à 6 sont des graphiques illustrant la quantification mise en oeuvre par l'invention par comparaison avec la quantification mise en oeuvre par un CAN flash classique ;
- la figure 7 est une vue schématique d'un premier mode de réalisation d'un étage amplificateur entrant dans la constitution du quantificateur de la figure 2 ;
- la figure 8 est une vue schématique d'un second mode de réalisation d'un étage amplificateur entrant dans la constitution du quantificateur de la figure 2 ;
- la figure 9 est une vue schématique d'un comparateur entrant dans la constitution du quantificateur de la figure 2 ;
- les figures 10 et 11 illustrent un discriminateur à hystérésis entrant dans la constitution du comparateur de la figure 9 ;
- les figures 12 à 14 sont des vues schématiques de différents modes de réalisation de cellule à retard entrant dans la constitution du quantificateur de la figure 2 ;
- la figure 15 est une vue schématique d'un CAN selon l'invention ;
- la figure 16 est une vue schématique d'un récepteur ultra-large bande selon l'invention ;
- les figures 17 à 22 sont des chronogrammes illustrant les différentes étapes de traitement mises en oeuvre par le CAN redresseur de la figure 16 ; et
- la figure 23 est une forme de réalisation particulière du récepteur de la figure 16.

## DESCRIPTION DETAILLEE DE L'INVENTION

QUANTIFICATEUR SELON L'INVENTION

Sur la figure 2, un quantificateur de tension à N bits **20** comprend $2^N$-1 étages de quantification $\mathbf{E_1^2 - E_{2^N-1}^2}$ agencés en série.

Chaque étage de quantification $\mathbf{E_1^2 - E_{2^N-1}^2}$ comporte :

- ■ un amplificateur de tension $\mathbf{G_1^2 - G_{2^N-1}^2}$ de gain prédéterminé ;
- ■ un comparateur de tension $\mathbf{C_1^2 - C_{2^N-1}^2}$, dont l'entrée positive (+) est connectée à la sortie de l'amplificateur de tension $\mathbf{G_1^2 - G_{2^N-1}^2}$, et dont l'entrée négative (-) reçoit une tension de seuil unique $\mathbf{V_{th}}$ ; et
- ■ une cellule à retard $\mathbf{D_1^2 - D_{2^N-1}^2}$, dont l'entrée est connectée à la sortie du comparateur de tension $\mathbf{C_1^2 - C_{2^N-1}^2}$, et qui applique un retard prédéterminé à cette sortie.

Les amplificateurs de tension $\mathbf{G_1^2 - G_{2^N-1}^2}$ sont connectés en série, le premier $\mathbf{G_1^2}$ d'entre eux recevant une tension à quantifier $\mathbf{V}_{in}$.

Les sorties des cellules à retard $\mathbf{D_1^2 - D_{2^N-1}^2}$ forment quant à elles les valeurs binaires quantifiées $\mathbf{Q_1}$-$\mathbf{Q_{2N-1}}$ du quantificateur **20** à N bits. Leur retard est sélectionné pour compenser le retard s'accumulant le long de la chaîne d'amplification formée des amplificateurs $\mathbf{G_1^2 - G_{2^N-1}^2}$, de manière à ce que les valeurs binaires $\mathbf{Q_1}$-$\mathbf{Q}_{2N-1}$ soient temporellement ajustées sur le même instant, et ainsi obtenir une cohérence temporelle pour celles-ci.

Ainsi, il est possible de quantifier de façon asynchrone un signal d'entrée en temps continu, c'est-à-dire un signal non échantillonné, les signaux fournis en continu en sortie des cellules de retard $\mathbf{D_1^2 - D_{2^N-1}^2}$ constituant les valeurs binaires quantifiées correspondant au signal d'entrée avec un décalage temporel correspondant au temps de propagation à travers le quantificateur.

On notera que la dernière cellule de retard

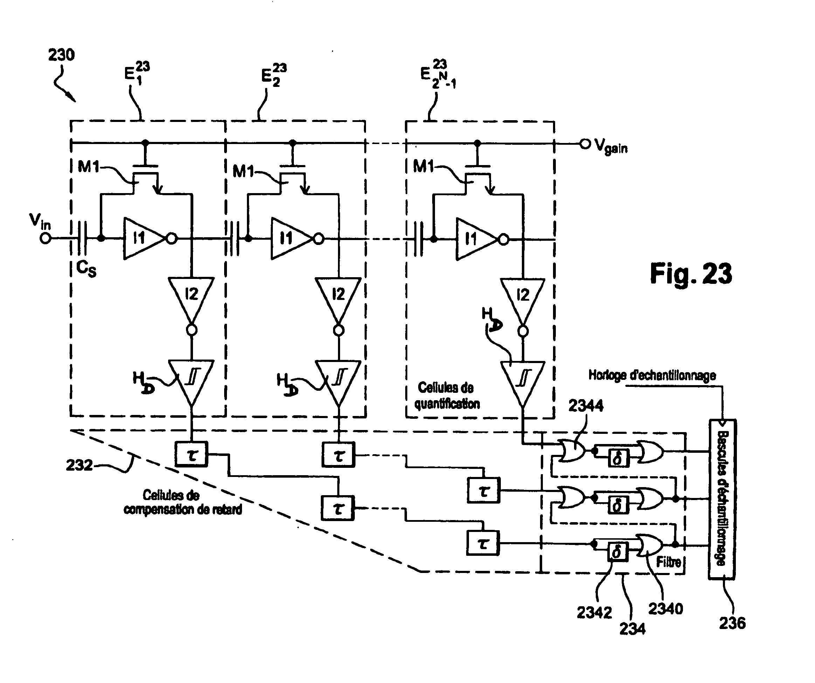

$\mathbf{D}^2_{2^N-1}$ est facultative, comme dans l'exemple relatif à la figure 23 ci-après décrit.

De manière facultative, le quantificateur **20** comporte également un étage **22** de détermination du signe de la tension $V_{in}$. L'étage **22** comporte un amplificateur **24,** agencé en série avec l'amplificateur $\mathbf{G}^2_{2^N-1}$ du dernier étage de quantification $\mathbf{E}^2_{2^N-1}$.

L'étage **22** comprend par ailleurs un comparateur **26,** connecté par son entrée positive (+) à la sortie de l'amplificateur **24,** et recevant sur son entrée négative (-) une tension nulle, la sortie du comparateur **26** donnant de ce fait le signe de la tension $V_{in}$.

Dans une première variante de réalisation du quantificateur de la figure 2, une quantification avec compression logarithmique est réalisée en choisissant pour les gains des amplificateurs $\mathbf{G}^2_1 - \mathbf{G}^2_{2^N-1}$ une valeur unique prédéterminée G.

En effet, dans un tel cas, la tension $V_{in}$ est quantifiée selon l'échelle de valeurs $\left\{\frac{V_{th}}{G^{2^N-1}},\ldots,\frac{V_{th}}{G^3},\frac{V_{th}}{G^2},\frac{V_{th}}{G}\right\}$. Cette variante est par exemple utile dans une application à la quantification d'un signal présentant une grande dynamique.

Dans une seconde variante de réalisation du quantificateur de la figure 2, une quantification avec une amplitude à pas constant, c'est-à-dire une quantification analogue à celle mise en oeuvre dans CAN flash classique, est réalisée en choisissant pour chaque amplificateur $\mathbf{G}^2_2 - \mathbf{G}^2_{2^N-1}$ à partir de la deuxième position dans la chaîne d'amplification un gain sensiblement égal à $\frac{\mathbf{i}}{\mathbf{i}-1}$, où i est la position de l'amplificateur dans cette chaîne.

En effet, dans un tel cas, la tension $V_{in}$ est quantifiée selon l'échelle de valeurs $\left\{\frac{V_{th}}{(2^N-1)\times G_1},\ldots,\frac{V_{th}}{3\times G_1},\frac{V_{th}}{2\times G_1},\frac{V_{th}}{G_1}\right\}$, où $G_1$ est le gain du premier amplificateur $\mathbf{G}^2_1$ dans la chaîne d'amplification.

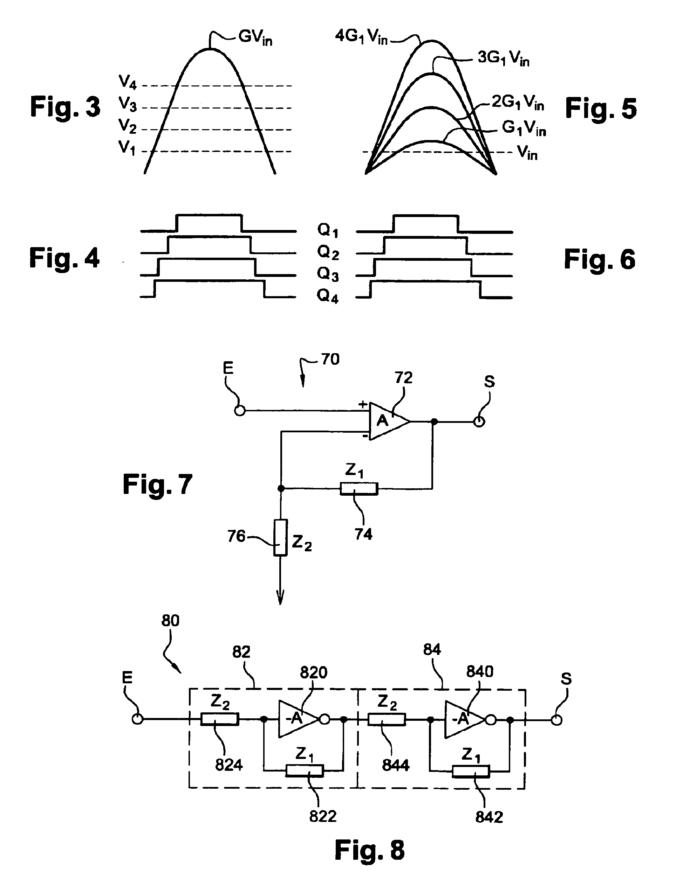

Les figures 3 à 6 illustrent une telle quantification avec amplitude à pas constant.

Les figures 3 et 4 illustrent la quantification mise en oeuvre par le CAN flash classique de la figure 1. Sur la figure 3, l'évolution temporelle de la tension amplifiée $G \times V_{in}$ en sortie de l'amplificateur $\mathbf{G}^1$ est représentée, ainsi que les quatre premières tensions de seuil $V_1$, $V_2$, $V_3$ et $V_4$. La figure 4 illustre l'évolution temporelle correspondante des quatre premières valeurs quantifiées $Q_1$, $Q_2$, $Q_3$ et $Q_4$ en sortie des quatre premiers comparateurs $\mathbf{C}^1_1$, $\mathbf{C}^1_2$, $\mathbf{C}^1_3$, $\mathbf{C}^1_4$.

Les figures 5 et 6 illustrent quant à elles la quantification avec amplitude à pas constant mise en oeuvre par le quantificateur de la figure 2, également pour les quatre premières valeurs quantifiées $Q_1$, $Q_2$, $Q_3$ et $Q_4$.

Comme on peut le constater, la quantification obtenue par la quantification de ces deux dispositifs est identique.

Toutefois, dans le CAN flash classique, il est nécessaire d'amplifier la tension $V_{in}$ avec un gain très important pour obtenir une comparaison avec l'ensemble des tensions de référence $V_1$, $V_2$, $V_3$, ..., $V_{2^N-1}$.

Dans le quantificateur selon l'invention, lorsqu'une tension de seuil unique $V_{th}$ est choisie pour l'ensemble des étages de quantification $\mathbf{E}^2_1 - \mathbf{E}^2_{2^N-1}$, il n'est pas nécessaire d'amplifier la tension pour être certain d'utiliser toute la plage dynamique de la quantification si les gains des amplificateurs sont choisis en conséquence et/ou sont des gains variables.

De préférence, les gains des amplificateurs $\mathbf{G}^2_1 - \mathbf{G}^2_{2^N-1}$ à partir du deuxième amplificateur $\mathbf{G}^2_2$ sont compris strictement entre 1 et 2. Le gain du premier amplificateur $\mathbf{G}^2_1$ peut quant à lui être égal à 1

On sait en effet qu'il est simple de réaliser des amplificateurs ayant de tels gains. En outre, de tels amplificateurs sont peu consommateurs d'énergie et présentent une grande linéarité en comparaison avec les amplificateurs de grand gain, tel que l'amplificateur $\mathbf{G}^1$ utilisé dans un CAN flash classique de la figure 1.

De préférence également, les gains des amplificateurs $\mathbf{G}^2_1 - \mathbf{G}^2_{2^N-1}$ sont sélectionnés en fonction de l'application particulière à laquelle est destiné le quantificateur.

Plus particulièrement, les amplificateurs présentent un gain non nul uniquement dans la bande de fréquence attendue de la tension $V_{in}$. Par exemple, dans le cas où il est attendu une tension $V_{in}$ ne comportant pas de composante continue, les gains des amplificateurs $\mathbf{G}^2_1 - \mathbf{G}^2_{2^N-1}$ sont du type passe-haut ou passe-bande, de manière à filtrer les basses fréquences.

Ceci est particulièrement avantageux car les effets de sélection de bandes de fréquences des amplificateurs se cumulent le long de la chaîne d'amplification. Ainsi, pour les derniers étages de quantification, une composante parasite, par exemple continue, reçue en entrée est sensiblement annulée par son filtrage successif au travers des amplificateurs $\mathbf{G}^2_1 - \mathbf{G}^2_{2^N-1}$. En considérant par exemple des gains identiques avec une atténuation de -20dB du continu, le filtrage du continu en sortie du quantificateur est de - $(2^N-1)$*20 dB, sans pour cela prévoir des filtres complexes.

Ceci est particulièrement avantageux dans la mesure où les derniers étages de quantification, qui correspondent aux bits de poids faible de la quantification, sont destinés à la quantification de signaux de faible valeur particulièrement sensibles aux bruits parasites et aux non linéarités.

En outre, le fait d'utiliser des amplificateurs à bande de fréquences limitée, permet d'utiliser également des comparateurs $C_1^2 - C_{2^N-1}^2$ à bande de fréquences limitée, moins consommateurs d'énergie que des comparateurs large bande, comme cela est usuellement le cas des CAN flash classiques.

Un premier mode de réalisation **70** d'un amplificateur $G_1^2 - G_{2^N-1}^2$ est illustré à la figure 7.

L'amplificateur **70** comporte :

- ■ un amplificateur différentiel **72** de gain A, recevant sur sa borne positive (+) la tension à amplifier, et délivrant en sortie la tension amplifiée,
- ■ une première impédance **74** de valeur $Z_1$, connectée entre la sortie de l'amplificaleur différentiel **72** et la borne négative (-) de celui-ci,
- ■ et une seconde impédance **76** de valeur $Z_2$, connectée entre la borne négative (-) de l'amplificateur différentiel **72** et la masse.

La fonction de transfert entre la sortie S et l'entrée E de l'amplificateur **70** est ainsi donnée par la relation :

$$\frac{S}{E} = \frac{A \times (Z_1 + Z_2)}{Z_1 + (1 + A) \times Z_2}.$$

La contre-réaction au moyen de l'impédance **74** a pour effet de régler le gain de l'amplificateur **70** avec précision. En effet, le réglage de gain est plus précis à l'aide du composant passif qu'est l'impédance **74** qu'avec l'aide d'un composant actif.

Les valeurs $Z_1$ et $Z_2$ des impédances **72** et **74** sont par ailleurs sélectionnées pour mettre en forme la réponse fréquentielle de l'amplificateur **70,** par exemple en fonction de la bande de fréquence de la tension à quantifier $V_{in}$, comme cela a été mentionné plus haut.

De préférence, les valeurs $Z_1$ et $Z_2$ sont également choisies pour que la fonction de transfert de l'amplificateur **70** soit du type passe haut, de manière à ne pas amplifier un décalage continu parasite $V_{offset}$ pouvant apparaître entre les bornes positive (+) et négative (-) de l'amplificateur différentiel **72.** On sait en effet qu'il est courant que la réponse de l'amplificateur différentiel **72** soit du type $S = A(V_+ - V_- + V_{offset})$, où $V_+$ et $V_-$ sont les tensions aux bornes positive (+) et négative (-) de l'amplificateur différentiel **72** respectivement et $V_{offset}$ un décalage continu parasite.

Aussi, pour le continu, la valeur de $Z_2$ est sensiblement supérieure à la valeur de $Z_1$. Par exemple, l'impédance **76** est une résistance, et l'impédance **74** est formée d'une résistance en parallèle avec une inductance, ou bien l'impédance **74** est une résistance et l'impédance **76** est formée d'une résistance en série avec un condensateur.

Lorsqu'une résistance est choisie pour l'une et/ou l'autre des impédances **74** et **76,** elle est de préférence mise en oeuvre sous la forme de la résistance entre le drain et la source d'un transistor MOS. La valeur de cette résistance, et donc celle du gain de l'amplificateur **70,** peut ainsi être réglée par la tension appliquée sur la grille du transistor MOS.

Un contrôle de gain est également mis en oeuvre par le pilotage de cette tension de grille.

La figure 8 est une vue schématique d'un second mode de réalisation **80** d'un amplificateur $G_1^2 - G_{2^N-1}^2$.

Selon ce mode de réalisation, l'amplificateur **80** comporte deux cellules identiques d'amplification **82, 84** agencées en série. Chaque cellule **82, 84** comporte un inverseur **820, 840** de gain A, dont la sortie forme celle-ci. La cellule **82, 84** comporte également une première impédance **822, 842** de valeur $Z_1$, connectée entre l'entrée et la sortie de l'inverseur **820, 840,** et une seconde impédance **824, 844** de valeur $Z_2$, connectée à l'une de ses bornes à l'entrée de l'inverseur **822, 842,** et dont l'autre borne forme l'entrée de la cellule **82, 84.** La fonction de transfert entre la sortie S et l'entrée E de l'amplificateur **80** est ainsi donnée par la relation :

$$\frac{S}{E} = \left( \frac{A \times Z_1}{Z_1 + (1 + A) \times Z_2} \right)^2$$

Les valeurs $Z_1$ et $Z_2$ des impédances sont sélectionnées de manière analogue au mode de réalisation décrit en relation avec la figure 7.

Ce deuxième mode de réalisation est avantageux car on a ici accès au signal inversé, ce qui permet d'avoir une comparaison sur les alternances positives et négatives du signal sans avoir à changer ni les comparateurs ni les seuils de comparaison. L'inverseur est en effet le plus simple des amplificateurs avec inversion. Un amplificateur opérationnel ne se justifie donc pas notamment en raison du filtrage du continu. Pour ce faire, on pourra rajouter un comparateur en sortie de chaque cellule 82 ou utiliser une seule cellule inverseuse (82 ou 84) pour chaque amplificateur.

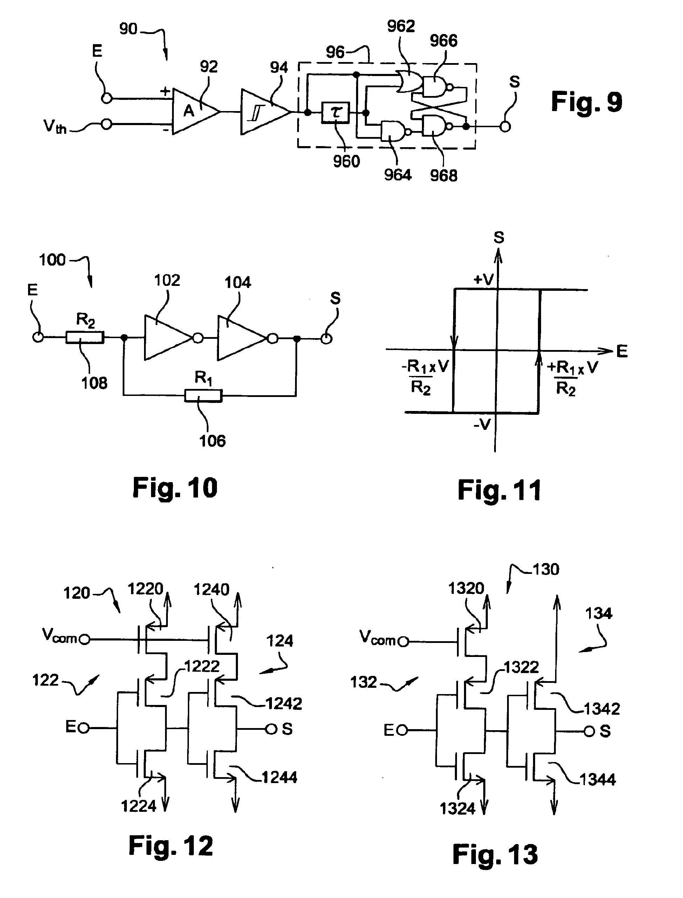

Sur la figure 9, il est illustré un mode de réalisation **90** d'un comparateur $C_1^2 - C_{2^N-1}^2$ du quantificateur de la figure 2.

Le comparateur **90** comprend un amplificateur différentiel **92** de gain A, recevant sur sa borne positive (+) la sortie de l'amplificateur $G_1^2 - G_{2^N-1}^2$, **24** auquel il est associé, et sur sa borne négative (-) la tension de seuil $V_{th}$.

Le comparateur **90** comporte également un discriminateur à hystérésis **94,** connecté en sortie de l'amplificateur différentiel **92.** Le discriminateur **94** prend la décision binaire quant au fait de savoir si la tension sur la borne (+) est supérieure à la tension sur la borne (-) de l'amplificateur **92** en fournissant en sortie un signal correctement saturé.

Enfin, optionnellement, le comparateur **90** comporte un filtre passe-bas détecteur de crête **96,** connecté en sortie du discriminateur **94.**

Ce filtre **96** comporte une cellule à retard **960,** connectée en sortie du discriminateur **94,** et appliquant un retard de valeur prédéterminée T à la tension qu'elle reçoit en entrée. Le filtre **96** comporte également des portes « OU » logique **962** et « NON-ET » logique **964,** connectées chacune en sortie du discriminateur **94** et de la cellule à retard **960,** ainsi qu'une bascule bistable RS sensible aux niveaux bas formée de deux portes « NON-ET » **966, 968** interconnectées.

Le filtre **96** élimine ainsi les impulsions de durée inférieure au retard $\tau$. La valeur de $\tau$ est de préférence choisie de manière à ce que son inverse soit supérieur ou égal à la fréquence de Shannon de la tension $V_{in}$ à quantifier. Ainsi, grâce au filtre **96,** les impulsions parasites, par exemple provoquées par des interférences de hautes fréquences, sont sensiblement éliminées.

La figure 10 est un exemple de réalisation **100** du discriminateur **94** et la figure 11 est une hystérésis mise en oeuvre par ce mode de réalisation du discriminateur **94.**

Le discriminateur **100** comporte deux inverseurs logiques **102, 104** en série, une première résistance **106** de valeur $R_1$ connectée en parallèle des deux inverseurs **102, 104,** ainsi qu'une seconde résistance **108** de valeur $R_2$, connectée en entrée du premier inverseur **102.** La borne libre de la seconde résistance **108** forme l'entrée E du discriminateur **100** et la sortie du second inverseur forme la sortie S de celui-ci.

Comme on peut le constater sur la figure 11, la tension d'hystérésis est sensiblement égale à $V \times \frac{R_1}{R_2}$, où V est la demi amplitude du résultat binaire, où 2V est la tension d'alimentation des inverseurs **102, 104,** c'est-à-dire également l'amplitude en sortie de ceux-ci..

Les figures 12 à 14 sont des vues schématiques de modes de réalisation **120, 130** et **140** de cellules à retard $D_1^2 - D_{2^N-1}^2$.

La cellule **120** de la figure 12 comporte deux branches **122, 124** de transistors MOS. Chaque branche est constituée :

- d'un premier transistor MOS à canal p **1220, 1240,** dont la source est connectée à la masse et dont la grille est connectée à une tension $V_{com}$ de réglage du retard de la cellule **120,**
- d'un second transistor MOS à canal p **1222, 1242,** dont la source est connectée au drain du premier transistor MOS **1220, 1240,**
- et d'un transistor MOS à canal n **1224, 1244,** dont le drain est connecté au drain du second transistor MOS **1222, 1242** et dont la source est connectée à la masse.

Les grilles du second transistor MOS à canal p **1222** et du transistor à canal n **1224** de la première branche **122** sont communes et sont connectées à l'entrée E de la cellule **120.** Les grilles du second transistor MOS à canal p **1242** et du transistor à canal n **1244** de la seconde branche **122** sont communes et sont connectées à la sortie S de la cellule **120.**

La cellule à retard **130** de la figure 13 est identique à celle de la figure 12 à la différence que le premier transistor MOS à canal p de la seconde branche est omis.

La cellule **120** de la figure 12 retarde à la fois les fronts montants et les fronts descendants d'un signal appliqué à l'entrée E, alors que la cellule **130** de la figure 13 ne retarde que les fronts descendants.

Par ailleurs, la présence du transistor MOS supplémentaire **1240** dans la cellule **120** a pour effet de limiter le courant de commutation des transistors en fonction de la tension de réglage Vcom.

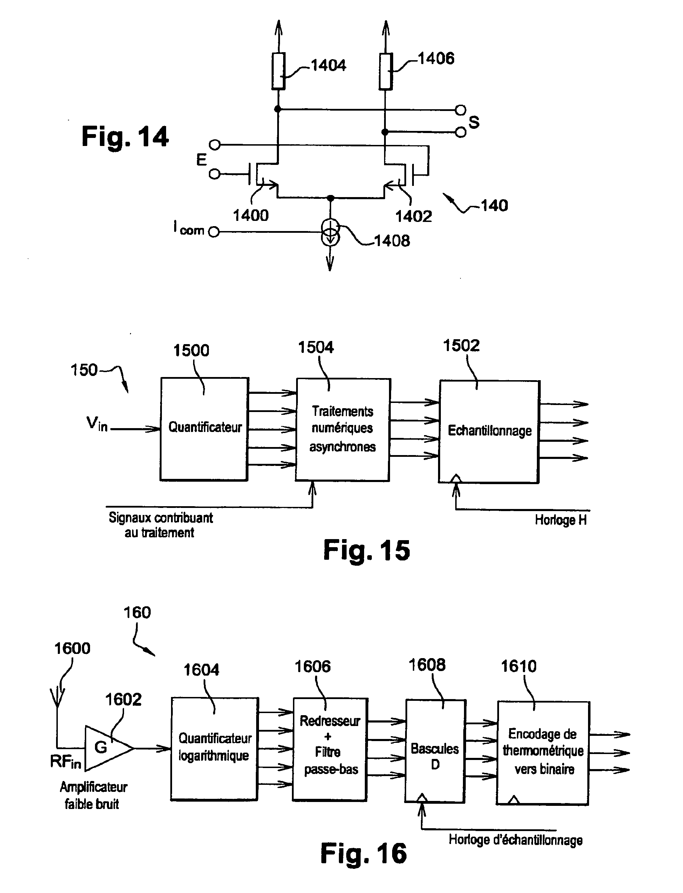

La cellule à retard **140** de la figure 14 comporte quant à elle deux transistors MOS à canal n **1400, 1402,** ayant leurs sources en commun, deux capacités **1404, 1406** connectées respectivement entre les drains des transistors **1400, 1402** et la masse, et une source de courant **1408** connectée entre les sources des transistors **1400, 1402** et la masse. L'entrée E de la cellule **140** est connectée aux grilles de ces transistors et la sortie S aux drains de ceux-ci. La valeur du retard appliqué par la cellule **140** est réglée par la valeur du courant $I_{com}$ de la source de courant **1408**

La cellule **140** présente une vitesse de fonctionnement plus élevée que celle des cellules **120, 130** des figures 12 et 13, mais nécessite en permanence le courant de polarisation $I_{com}$.

## CONVERTISSEUR ANALOGIQUE/NUMERIQUE SELON L'INVENTION

La figure 15 est une vue schématique d'un convertisseur analogique-numérique **150** incorporant un quantificateur selon l'invention.

Le CAN comporte un quantificateur **1500** selon l'invention, par exemple celui de la figure 2, et un échantillonneur **1502,** dont la fréquence d'échantillonnage est celle d'une horloge H. L'échantillonneur est par exemple formé d'un registre de $2^N$-1 bascules D.

De manière particulièrement avantageuse, le CAN **150** comprend également un circuit de traitement numérique asynchrone **1504,** agencé entre le quantificateur **1500** et l'échantillonneur **1502,** et mettant en oeuvre toute opération jugée utile sur le signal quantifié.

Le traitement des valeurs quantifiées de la tension $V_{in}$ est ainsi réalisé avant échantillonnage. Ceci est rendu possible par le fait que le quantificateur selon l'invention est par nature asynchrone du fait des retards de propagation du signal le long de la chaîne d'amplification.

Classiquement, dans le cas d'un CAN flash, un traitement est réalisé sur les valeurs quantifiées et échantillonnées en sortie de celui-ci. Or, on sait qu'un traitement sur de telles valeurs nécessite en réalité de reconvertir les valeurs échantillonnées en valeurs numériques pour permettre des opérations logiques. La réalisation d'un traitement sur les valeurs quantifiées non échantillonnées permet ainsi de faire l'économie de cette étape, impliquant de fait un gain en vitesse de fonctionnement et en consommation.

Bien entendu, il est également possible de ne prévoir aucun traitement numérique des valeurs quantifiées avant leur échantillonnage. Dans un tel cas, le quantificateur est directement connecté à l'échantillonneur.

APPLICATION A LA RECEPTION ULTRA LARGE BANDE IMPULSIONNELLE

La transmission radio d'informations numériques ou analogiques est usuellement réalisée en convertissant par modulation ces informations en un signal, dont le domaine fréquentiel, constitué d'une ou plusieurs bandes de hautes fréquences, est compatible avec la transmission par onde radiofréquence (RF). Cette transmission se fait sans support filaire, et en général dans un canal de transmission qui est constitué par l'environnement (air ou vide par exemple) situé entre l'émetteur et le récepteur du signal RF. Une fois reçu, le signal RF est démodulé pour retrouver les informations initiales dans leur bande de base fréquentielle.

On distingue au moins deux types de transmission RF, à savoir une transmission par porteuse modulée et une transmission par des signaux impulsionnels, par exemple du type radar.

Dans le cas d'une transmission par porteuse modulée, le signal RF est produit par la combinaison d'un ou de plusieurs signaux sinusoïdaux modulés, qui ont la particularité d'être émis pendant une grande partie, voire la totalité de la durée de transmission. L'émission du signal RF est donc réalisée de manière continue.

Dans le cas d'une transmission RF par des signaux impulsionnels, le signal RF est une impulsion modulée, en général de courte durée par rapport à la durée totale de transmission, mais répétée régulièrement. L'émission se fait donc de manière discontinue. Les impulsions courtes occupant un spectre de fréquences très large, on parle souvent de transmission de type ultra large bande impulsionnel (UWB).

Aujourd'hui, de nombreux émetteurs-récepteurs RF sont conçus pour envoyer des informations numériques plutôt que des informations analogiques en raison des possibilités toujours plus grandes qu'offrent le traitement numérique des signaux. On observe ainsi, dans un récepteur RF, qu'une conversion analogique-numérique est réalisée au plus tôt après la réception, parfois même en sortie de l'antenne de réception, pour profiter le plus rapidement possible des avantages qu'offre le traitement numérique.

Toutefois, placer un convertisseur analogique-numérique au plus près de l'antenne du récepteur RF, c'est-à-dire en amont des composants de démodulation qui convertissent le signal dans la bande de base, oblige, sauf cas très particuliers de sous-échantillonnage, à échantillonner à au moins deux fois la plus haute fréquence du spectre du signal RF reçu. Or, un échantillonnage à très haute fréquence (de l'ordre de plusieurs gigahertz) implique d'une part l'utilisation de convertisseurs très rapides, usuellement des CAN flash, et d'autre part une démodulation numérique à partir d'un flux très important de données (de l'ordre du gigaoctet par seconde).

De tels récepteurs RF n'ont pour l'instant pas donné satisfaction, notamment en ce qui concerne la consommation.

Par ailleurs, dans le cas de la détection UWB non cohérente par détection de l'énergie des impulsions du signal RF reçu, par exemple décrite dans le document WO 2005/074150, une approximation de la puissance instantanée du signal RF reçu est réalisée en mesurant la valeur absolue de ce signal au moyen d'un redressement de celui-ci.

Or, un redressement efficace est obtenu pour un signal d'amplitude suffisamment importante. Aussi, dans le récepteur UWB non cohérent par détection d'énergie, il est nécessaire de prévoir une forte amplification de l'amplitude du signal reçu, typiquement une amplification de l'ordre de 70 dB. Une partie du gain de l'amplification est usuellement obtenue par l'amplificateur faible bruit, typiquement un gain de l'ordre de 20dB. Le reste de l'amplification est réalisée à l'aide d'étages amplificateurs spécifiques.

La figure 16 est une vue schématique d'un récepteur UWB **160** non cohérent par détection d'énergie. Ce récepteur **160** comporte un CAN selon l'invention. Ce CAN résout à la fois le problème de consommation d'énergie et le problème de l'échantillonnage à très haute fréquence par l'utilisation d'un quantificateur selon l'invention, peu gourmand en énergie et permettant de séparer la fonction de quantification de la fonction d'échantillonnage.

Le récepteur UWB **160** comporte une antenne de réception RF **1600** et un amplificateur faible bruit **1602** classiques.

Le récepteur **160** comporte en outre un quantificateur à compression logarithmique **1604** selon l'invention, tel que décrit en relation avec la figure 2. Le quantificateur **1604** est connecté à l'amplificateur **1602** et quantifie le signal RF amplifié en sortie de ce dernier.

Un module **1606,** appliquant une fonction de redressement et de filtrage et passe-bas, est également prévu en sortie du quantificateur **1604.**

Le redressement mis en oeuvre par le module **1606** consiste par exemple à régler le signe du signal quantifié à 0.

Le filtrage passe-bas du module **1606,** par exemple sous la forme d'un filtre à réponse impulsionnelle finie ou infinie, réduit sensiblement la bande passante du signal quantifié de manière à baisser d'un ordre de grandeur la fréquence de l'échantillonnage mise en oeuvre ultérieurement. Il n'est ainsi conservé que l'enveloppe du signal reçu, c'est-à-dire la partie utile de celui-ci.

Par ailleurs, un échantillonneur **1608,** formé d'un registre à $2^N$-1 bascules monostables du type D, est connecté en sortie du filtre passe-bas pour l'échantillonnage des valeurs quantifiées délivrées par celui-ci.

Enfin, un encodeur thermométrique **1610,** connecté à l'échantillonneur **1608,** encode les valeurs quantifiées et échantillonnées en sortie de celui-ci, selon un codage binaire souhaité, comme un codage gray par exemple.

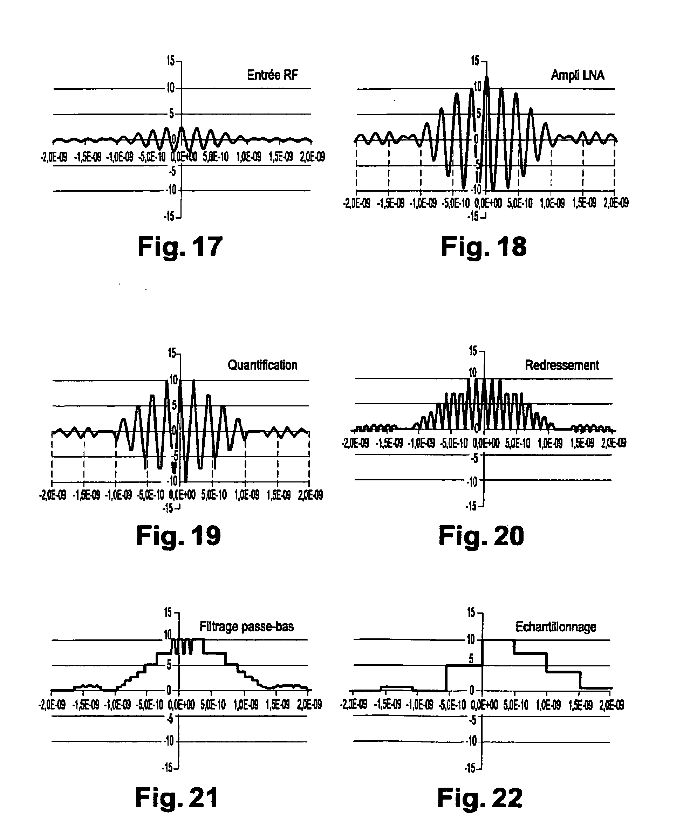

Les figures 17 à 22 illustrent les différentes étapes de traitement réalisées par le récepteur **160** sur un exemple d'impulsions reçues, ici du type racine carrée de cosinus surélevé à une fréquence centrale de 4,5 GHz et ayant une bande de fréquences de 700 MHz. La fréquence d'échantillonnage est ici de 2 GHz.

La figure 23 est un autre mode de réalisation du quantificateur **1604,** du module de redressement et de filtrage passe-bas **1606** et d'échantillonnage **1608** du récepteur **160** de la figure 16.

Dans cette forme de réalisation, le quantificateur, ici désigné sous la référence **230,** est formé de $2^N$-1 étages de quantification $\mathbf{E}_1^{23}$ - $\mathbf{E}_{2^N-1}^{23}$ agencés en série et d'une matrice triangulaire **232** de cellules à retard de valeur T.

Chacun de ces étages $\mathbf{E}_1^{23}$ - $\mathbf{E}_{2^N-1}^{23}$ comporte un premier inverseur CMOS **I1,** dont la sortie forme la sortie de l'étage, un transistor CMOS à canal n **M1** et un condensateur **Cs,** connecté à l'une de ses bornes à la borne entrée de l'inverseur **I1** et dont l'autre bornes forme l'entrée de l'étage de quantification $\mathbf{E}_1^{23}$ - $\mathbf{E}_{2^N-1}^{23}$.

Le condensateur **Cs** réalise le filtrage d'une composante continue parasite du signal $V_{in}$ à quantifier. En effet, dans le cadre de l'application à la réception UWB, le signal ne comporte pas de composante continue lorsqu'il n'est pas parasité.

Le chemin drain-source du transistor **M1** est monté en contre-réaction sur le premier inverseur **I1,** et la grille du transistor **M1** est connectée à une tension de commande Vgain. La valeur de la tension de grille Vgain du transistor **M1** règle le gain de l'amplification réalisée par l'étage d'amplification, gain qui est ici négatif.

Chaque étage de quantification $\mathbf{E}_1^{23}$ - $\mathbf{E}_{2^N-1}^{23}$ comporte en outre un second inverseur CMOS **12,** connecté en sortie du premier inverseur **I1.** Le second inverseur **I2** est choisi différent du premier inverseur **I1** de manière à ce que l'inverseur **12** amplifie la sortie du premier inverseur **I1** avec un biais en tension prédéterminé. Ce biais correspond à la tension de seuil $V_{th}$ souhaitée pour la quantification mise en oeuvre par l'étage de quantification $\mathbf{E}_1^{23}$ - $\mathbf{E}_{2^N-1}^{23}$. Ceci est par exemple réalisé en choisissant des transistors de taille différente pour les inverseurs **I1** et **I2.**

Enfin, chaque étage de quantification $\mathbf{E}_1^{23}$ - $\mathbf{E}_{2^N-1}^{23}$ comprend un discriminateur à hystérésis $H_D$, par exemple celui décrit en relation avec la figure 10.

La matrice triangulaire **232** comporte quant à elle une série de cellules à retard consécutives pour chaque étage de quantification $\mathbf{E}_1^{23}$ - $\mathbf{E}_{2^N-1}^{23}$, le nombre de cellules à retard consécutives pour le i[ème] étage de quantification étant égal à de $2^N$-1-i, de manière à compenser le temps de propagation dans les étages $\mathbf{E}_1^{23}$ - $\mathbf{E}_{2^N-1}^{23}$.

Le quantificateur **230** comporte en outre un filtre **234.** Le filtre **234** réalise, en combinaison avec les étages de quantification $\mathbf{E}_1^{23}$.- $\mathbf{E}_{2^N-1}^{23}$, une fonction de redressement.

Plus particulièrement, en supposant les gains égaux à -G pour les étages de quantification $\mathbf{E}_1^{23}$ - $\mathbf{E}_{2^N-1}^{23}$, avec G un nombre positif prédéterminé, il est réalisé au moyen des étages de quantification impairs $\mathbf{E}_1^{23}$, $\mathbf{E}_3^{23}$,..., $\mathbf{E}_{2^N-1}^{23}$ une comparaison de la tension $V_{in}$ à quantifier (la tension en sortie de l'amplificateur faible bruit) avec les valeurs

$$\left\{-\frac{V_{th}}{G^{2^N-1}},\ldots,-\frac{V_{th}}{G^3},-\frac{V_{th}}{G}\right\}.$$

Par ailleurs, il est réalisé au moyen des étages de quantification pairs $\mathbf{E}_2^{23}$, $\mathbf{E}_4^{23}$,..., $\mathbf{E}_{2^N-2}^{23}$ une comparaison de la tension $V_{in}$ avec les valeurs

$$\left\{\frac{V_{th}}{G^{2^N-2}},\ldots,\frac{V_{th}}{G^4},\frac{V_{th}}{G^2}\right\}.$$

De fait, les étages impairs réalisent une quantification de la valeur absolue des alternances négatives de la tension $V_{in}$ alors que les étages pairs réalisent une quantification de la valeur absolue des alternances positives de la tension $V_{in}$. Une quantification entrelacée des alternances positives et négatives de la tension $V_{in}$ est ainsi obtenue.

Le filtre **234** réalise également un filtrage passe-bas par détection de crête. Ce filtrage est effectué en allongeant, d'une durée δ prédéterminée, chaque valeur quantifiée $Q_1$-$Q_{2N-1}$ en sortie de la matrice **232.** Pour chacune des valeurs quantifiées $Q_1$-$Q_{2N-1}$, le filtre **234** comporte à cet effet une porte « OU » **2340** au travers de laquelle la valeur quantifié est combinée avec une valeur d'elle-même retardée au moyen d'une cellule à retard **2342** de valeur δ.

Le filtre **234** combine également, au moyen de portes « OU » **2344,** les valeurs quantifiées allongées associées à deux étages de quantification consécutifs. Par exemple, en notant $Q'_1 - Q'_{2^N-1}$ les valeurs quantifiées allongées, le filtre **234** réalise, hormis pour la première valeur quantifiée allongée $Q'_1$, les combinaisons logiques $Q''_i = Q'_i \text{ OU } Q'_{i+1}$. Il est ainsi obtenu un redressement des alternances négatives quantifiées de la tension $V_{in}$.

Enfin, un échantillonneur **236** est également prévu pour échantillonner les valeurs quantifiées, allongées et redressées en sortie du filtre **234.**

Bien qu'il ait été décrit un quantificateur à valeur de seuil unique, on comprendra qu'il est possible de choisir des valeurs différentes pour la comparaison.

## Revendications

**1.** Quantificateur asynchrone à N bits (20 ; 230, 232, 234) comprenant :

- $2^N$-1 étages amplificateurs de signal ( $G_1^2 - G_{2^N-1}^2$ ; I1, Cs, M1) agencés en série, l'entrée du premier étage étant apte à recevoir un signal à quantifier ;
- $2^N$-1 comparateurs ( $C_1^2 - C_{2^N-1}^2$ ; I2, $H_D$), un comparateur étant connecté à la sortie de chaque étage amplificateur ( $G_1^2 - G_{2^N-1}^2$ ; I1, Cs, M1), et apte à comparer la valeur de cette sortie à une valeur de seuil prédéterminée ; et
- au moins $2^N$-2 lignes à retard $(D_1^2 - D_{2^N-1}^2)$ placées en sortie des $2^N$-2 premiers comparateurs, les signaux fournis en sortie des lignes à retard $(D_1^2 - D_{2^N-1}^2)$ et du dernier comparateur constituant à tout instant les valeurs binaires quantifiées du signal d'entrée avec un décalage temporel.

**2.** Quantificateur selon la revendication 1, ***caractérisé* en ce que** la valeur absolue du gain d'un étage amplificateur ( $G_1^2 - G_{2^N-1}^2$ ; I1, Cs, M1) est comprise entre environ 1 et environ 2.

**3.** Quantificateur selon l'une des revendications 1 et 2, ***caractérisé* en ce que** le gain des étages amplificateurs ( $G_1^2 - G_{2^N-1}^2$ ; I1, Cs, M1) est sensiblement identique.

**4.** Quantificateur selon l'une des revendications 1 et 2, ***caractérisé* en ce que** la valeur absolue du gain d'un étage amplificateur ( $G_1^2 - G_{2^N-1}^2$ ; I1, Cs, M1), hormis le premier, est sensiblement égal à i/(i-1)*G1, où G1 est le gain du premier étage amplificateur et i la position de l'étage amplificateur dans la série d'étages amplificateurs.

**5.** Quantificateur selon l'une des revendications 1 et 2, ***caractérisé* en ce que** le gain des étages amplificateurs est négatif.

**6.** Quantificateur selon l'une quelconque des revendications précédentes, ***caractérisé* en ce qu'**un étage amplificateur ( $G_1^2 - G_{2^N-1}^2$ ; I1, Cs, M1) est également agencé pour filtrer la composante continue du signal à quantifier.

**7.** Quantificateur selon l'une quelconque des revendications précédentes, ***caractérisé* en ce que** chaque étage amplificateur ( $G_1^2 - G_{2^N-1}^2$ ; I1, Cs, M1) est du type à contrôle de gain automatique.

**8.** Quantificateur selon l'une quelconque des revendications précédentes, ***caractérisé* en ce que** chaque étage amplificateur $(G_1^2 - G_{2^N-1}^2)$ comporte :

- un amplificateur différentiel (72), dont une entrée positive forme l'entrée de l'étage amplificateur ;
- une première impédance (74), connectée entre une entrée négative et une sortie de l'amplificateur différentiel (72); et
- une seconde impédance (76), connectée entre l'entrée négative de l'amplificateur différentielle et la masse.

**9.** Quantificateur selon l'une quelconque des revendications 1 à 7, ***caractérisé* en ce que** chaque étage amplificateur $(G_1^2 - G_{2^N-1}^2)$ comporte un agencement série de deux cellules amplificatrices (82, 84), chacune de ces cellules (82, 84) étant composée :

- d'un inverseur (820, 840), dont la sortie forme la sortie de la cellule (82, 84),
- d'une première impédance (822, 842), connectée entre l'entrée et la sortie de l'inverseur (820, 840), et
- d'une seconde impédance (824, 844), connectée à l'une de ses bornes à l'entrée de l'inverseur (820, 840), et dont l'autre borne forme l'entrée de la cellule (82, 84).

**10.** Quantificateur selon l'une quelconque des revendications 1 à 7, ***caractérisé* en ce que** chaque étage amplificateur (I1, Cs, M1) comporte :

- ■ un inverseur (I1), dont la sortie forme la sortie de l'étage amplificateur,
- ■ une première impédance (M1) connectée entre l'entrée et la sortie de l'inverseur (I1), et
- ■ une seconde impédance (Cs) connectée à l'une de ses bornes à l'entrée de l'inverseur, et dont l'autre borne forme l'entrée de l'étage.

**11.** Quantificateur selon la revendication 5 ou 10, ***caractérisé* en ce qu'**il comporte en outre un module (234) de traitement numérique apte à appliquer une fonction « OU » à chaque paire de sorties consécutives des lignes à retard et du dernier comparateur, le résultat de la fonction « OU » formant une valeur binaire quantifiée.

**12.** Quantificateur selon la revendication 8, 9, 10 ou 11, ***caractérisé* en ce que** la valeur en continue de la seconde impédance (76 ; 824, 844 ; Cs) est sensiblement supérieure à la valeur en continue de la première impédance (74 ; 822, 842 ; M1).

**13.** Quantificateur selon la revendication 8, 9, 10, 11 ou 12, ***caractérisé* en ce que** la première impédance (M1) est celle définie entre le drain et la source d'un transistor MOS.

**14.** Quantificateur selon l'une quelconque des revendications précédentes, ***caractérisé* en ce que** la valeur de seuil est unique pour l'ensemble des comparateurs ( $C_1^2 - C_{2^N-1}^2$ ; I2, H).

**15.** Quantificateur selon l'une quelconque des revendications précédentes, ***caractérisé* en ce que** chaque comparateur $(C_1^2 - C_{2^N-1}^2)$ comporte:

- ■ un amplificateur différentiel à grand gain (92), recevant sur une entrée positive la sortie de l'étage amplificateur correspondant, et sur une entrée négative la valeur de seuil correspondante, et
- ■ un module de prise de décision binaire (94), connecté en sortie de l'amplificateur différentiel à grand gain.

**16.** Quantificateur selon la revendication 15, ***caractérisé* en ce que** le module de prise de décision binaire (94) comprend un discriminateur à hystérésis (94).

**17.** Quantificateur selon la revendication 15 ou 16, ***caractérisé* en ce qu'**il comporte en outre un module (96) de filtrage connecté en sortie du module (94) de prise de décision binaire pour éliminer les impulsions de durée inférieure à une durée prédéterminée.

**18.** Quantificateur selon l'une quelconque des revendications précédentes, ***caractérisé* en ce que** chaque ligne à retard (232) comporte $2^N$-1-i des cellules à retard sensiblement identiques, où i est la position de l'étage amplificateur (I1, M1, Cs) associé à la ligne dans la série d'étages amplificateurs.

**19.** Quantificateur selon l'une quelconque des revendications précédentes, ***caractérisé* en ce qu'**il comporte en outre, en début ou en fin de la série d'étages amplificateurs, un étage amplificateur supplémentaire (22), et un comparateur supplémentaire (26) connecté à la sortie de l'étage amplificateur supplémentaire (22) et apte à comparer la sortie de celui-ci à la valeur nulle pour déterminer le signe du signal à quantifier.

**20.** Convertisseur analogique-numérique à N bits (150) comprenant un quantificateur (1500) selon l'une quelconque des revendications précédentes et un échantillonneur (1502) relié au quantificateur et apte à échantillonner les signaux qu'il reçoit en entrée.

**21.** Convertisseur analogique-numérique selon la revendication 20, ***caractérisé* en ce qu'**il comporte un module de traitement numérique (1504) connecté entre le quantificateur (1500) et l'échantillonneur (1502).

**22.** Récepteur radiofréquence (160), du type intégrant un convertisseur (1604, 1606, 1608) selon l'une des revendications 20 ou 21.

**23.** Récepteur radiofréquence selon la revendication 22, ***caractérisé* en ce que** le quantificateur met en oeuvre une quantification avec compression logarithmique.

**24.** Récepteur radiofréquence selon la revendication 22 ou 23, ***caractérisé* en ce qu'**il est apte à recevoir des signaux radiofréquence de porteuse modulée.

**25.** Récepteur radiofréquence selon la revendication 22 ou 23, **caractérisé en ce qu'**il est apte à recevoir des signaux radiofréquence ultra-large bande.

## Claims

**1.** N-bit asynchronous quantizer (20; 230, 232, 234) including:

■ $2^N$-1 signal amplifier stages ( $G_1^2 - G_{2^N-1}^2$ ; I1, Cs, M1) arranged in series, the input of the first stage being capable of receiving a signal to be quantized;

■ $2^N$-1 comparators ( $C_1^2 - C_{2^N-1}^2$ ; I2, $H_D$), one comparator being connected to the output of each amplifier stage ( $G_1^2 - G_{2^N-1}^2$ ; I1, Cs, M1), and capable of comparing the value of this output with a predetermined threshold value; and

■ at least $2^N$-2 delay lines ( $D_1^2 - D_{2^N-1}^2$ ) placed at the output of the $2^N$-2 first comparators, the signals supplied at the output of the delay lines ( $D_1^2 - D_{2^N-1}^2$ ) and of the last comparator constituting at any instant the quantized binary values of the input signal with a time shift.

**2.** Quantizer as claimed in claim 1, ***characterized* in that** the absolute value of the gain of an amplifier stage ( $G_1^2 - G_{2^N-1}^2$ ; I1, Cs, M1) is between about 1 and about 2.

**3.** Quantizer as claimed in one of claims 1 and 2, ***characterized* in that** the gain of the amplifier stages ( $G_1^2 - G_{2^N-1}^2$ ; I1, Cs, M1) is substantially identical.

**4.** Quantizer as claimed in one of claims 1 and 2, ***characterized* in that** the absolute value of the gain of an amplifier stage ( $G_1^2 - G_{2^N-1}^2$ ; I1, Cs, M1), apart from the first one, is substantially equal to i/(i-1)*G1, where G1 is the gain of the first amplifier stage and i the position of the amplifier stage in the amplifier stage sequence.

**5.** Quantizer as claimed in one of claims 1 and 2, ***characterized* in that** the gain of the amplifier stages is negative.

**6.** Quantizer as claimed in any one of the previous claims, ***characterized* in that** an amplifier stage ( $G_1^2 - G_{2^N-1}^2$ ; I1, Cs, M1) is also arranged to filter the DC component of the signal to be quantized.

**7.** Quantizer as claimed in any one of the previous claims, ***characterized* in that** each amplifier stage ( $G_1^2 - G_{2^N-1}^2$ ; I1, Cs, M1) is of the automatic gain control type.

**8.** Quantizer as claimed in any one of the previous claims, ***characterized* in that** each amplifier stage ( $G_1^2 - G_{2^N-1}^2$ ) comprises:

■ a differential amplifier (72), whereof a positive input constitutes the input of the amplifier stage;
■ a first impedance (74), connected between a negative input and an output of the differential amplifier (72); and
■ a second impedance (76), connected between the negative input of the differential amplifier and the earth.

**9.** Quantizer as claimed in any one of claims 1 to 7, ***characterized* in that** each amplifier stage ( $G_1^2 - G_{2^N-1}^2$ ) comprises a series arrangement of two amplifier cells (82, 84), each of the cells (82, 84) consisting of:

■ an inverter (820, 840), whereof the output constitutes the output of the cell (82, 84),
■ a first impedance (822, 842), connected between the input and the output of the inverter (820, 840), and
■ a second impedance (824, 844), connected at one of its terminals to the input of the inverter (820, 840), and whereof the other terminal constitutes the input of the cell (82, 84).

**10.** Quantizer as claimed in any one of claims 1 to 7, ***characterized* in that** each amplifier stage (I1, Cs, M1) comprises:

■ an inverter (I1), whereof the output constitutes the output of the amplifier stage,
■ a first impedance (M1) connected between the input and the output of the inverter (I1), and
■ a second impedance (Cs) connected at one of its terminals to the input of the inverter, and whereof the other terminal constitutes the input of the stage.

**11.** Quantizer as claimed in claim 5 or 10, ***characterized* in that** it further comprises a digital processing module (234) capable of applying an "OR" function to each pair of consecutive outputs of the delay lines and of the last comparator, the "OR" function outcome constituting a quantized binary value.

**12.** Quantizer as claimed in claim 8, 9, 10 or 11, ***characterized* in that** the DC value of the second impedance (76; 824, 844; Cs) is substantially greater than the DC value of the first impedance (74; 822, 842; M1).

**13.** Quantizer as claimed in claim 8, 9, 10, 11 or 12, ***characterized* in that** the first impedance (M1) is the one defined between the drain and the source of an MOS transistor.

**14.** Quantizer as claimed in any one of the previous claims, ***characterized* in that** the threshold value is unique for all the comparators ( $C_1^2 - C_{2^N-1}^2$ ; I2, H).

**15.** Quantizer as claimed in any one of the previous claims, ***characterized* in that** each comparator ( $C_1^2 - C_{2^N-1}^2$ ) comprises:

■ a high-gain differential amplifier (92), receiving on a positive input the output of the corresponding amplifier stage, and on a negative input the corresponding threshold value, and
■ a binary decision-making module (94), connected at the output of the high-gain differential amplifier.

**16.** Quantizer as claimed in claim 15, ***characterized* in that** the binary decision-making module (94) includes a discriminator with hysteresis (94).

**17.** Quantizer as claimed in claim 15 or 16, ***characterized* in that** it further comprises a filtering module (96) connected at the output of the binary decision-making module (94) in order to eliminate pulses of duration less than a predetermined duration.

**18.** Quantizer as claimed in any one of the previous claims, ***characterized* in that** each delay line (232) comprises $2^N$-1-i of the substantially identical delay cells, where i is the position of the amplifier stage (I1, M1, Cs) associated with the delay line in the amplifier stage sequence.

**19.** Quantizer as claimed in any one of the previous claims, ***characterized* in that** it further comprises, at the start or at the end of the amplifier stage sequence, an additional amplifier stage (22), and an additional comparator (26) connected to the output of the additional amplifier stage (22) and capable of comparing the output thereof with the zero value in order to determine the sign of the signal to be quantized.

**20.** N-bit analogue-to-digital converter (150) including a quantizer (1500) as claimed in any one of the previous claims and a sampler (1502) connected to the quantizer and capable of sampling the signals it receives at input.

**21.** Analogue-to-digital converter as claimed in claim 20, ***characterized* in that** it comprises a digital processing module (1504) connected between the quantizer (1500) and the sampler (1502).

**22.** Radio-frequency receiver (160), of the type with a built-in converter (1604, 1606, 1608) as claimed in one of claims 20 or 21.

**23.** Radio-frequency receiver as claimed in claim 22, ***characterized* in that** the quantizer implements a quantization with logarithmic compression.

**24.** Radio-frequency receiver as claimed in claim 22 or 23, ***characterized* in that** it is capable of receiving radio-frequency signals with a modulated carrier.

**25.** Radio-frequency receiver as claimed in claim 22 or 23, ***characterized* in that** it is capable of receiving radio-frequency ultra-wide band signals.

**Patentansprüche**

**1.** Asynchroner N-Bit-Quantisierer (20; 230; 232; 234), Folgendes umfassend:

■ $2^N$-1 Signalverstärkerstufen ( $G_1^2 - G_{2^N-1}^2$ ; I1, Cs, M1) in Reihenschaltung, wobei der Eingang der ersten Stufe ausgebildet ist, ein zu quantisierendes Signal zu empfangen;

■ $2^N$-1 Komparatoren ( $C_1^2 - C_{2^N-1}^2$ ; I2, $H_D$), wobei ein Komparator auf den Ausgang jeder Verstärkerstufe ( $G_1^2 - G_{2^N-1}^2$ ; I1, Cs, M1) aufgeschaltet ist und ausgebildet ist, den Wert dieses Ausgangs mit einem vorbestimmten Schwellenwert zu vergleichen; und

■ mindestens $2^N$-2 Verzögerungsleitungen ( $D_1^2 - D_{2^N-1}^2$ ), die am Ausgang der $2^N$-2 ersten Komparatoren angesetzt sind, wobei die am Ausgang der Verzögerungsleitungen ( $D_1^2 - D_{2^N-1}^2$ ) bereitgestellten Signale und des letzten Komparators jederzeit die quantisierten Binärwerte des Eingangssignals mit einem zeitlichen Versatz darstellen.

**2.** Quantisierer nach Anspruch 1, **dadurch gekennzeichnet, dass** der Absolutwert der Verstärkung einer Verstärkerstufe ( $G_1^2 - G_{2^N-1}^2$ ; I1, Cs, M1) zwischen ca. 1 und ca. 2 beträgt.

**3.** Quantisierer nach einem der Ansprüche 1 und 2, **dadurch gekennzeichnet, dass** die Verstärkung der Verstärkerstufen ( $G_1^2 - G_{2^N-1}^2$ ; I1, Cs, M1) im Wesentlichen gleich ist.

**4.** Quantisierer nach einem der Ansprüche 1 und 2, **dadurch gekennzeichnet, dass** der Absolutwert der Verstärkung einer Verstärkerstufe ( $G_1^2 - G_{2^N-1}^2$; I1, Cs, M1), mit Ausnahme der ersten, im Wesentlichen gleich i/(i-1)*G1 ist, wobei G1 die Verstärkung der ersten Verstärkerstufe und i die Position der Verstärkerstufe in der Verstärkerstufenreihe ist.

**5.** Quantisierer nach einem der Ansprüche 1 und 2, **dadurch gekennzeichnet, dass** die Verstärkung der Verstärkerstufen negativ ist.

**6.** Quantisierer nach einem der vorhergehenden Ansprüche, **dadurch gekennzeichnet, dass** eine Verstärkerstufe ( $G_1^2 - G_{2^N-1}^2$; I1, Cs, M1) auch dazu eingerichtet ist, die stetige Komponente des zu quantisierenden Signals zu filtern.

**7.** Quantisierer nach einem der vorhergehenden Ansprüche, **dadurch gekennzeichnet, dass** jede Verstärkerstufe ( $G_1^2 - G_{2^N-1}^2$; I1, Cs, M1) von der Art mit automatischer Verstärkungsregelung ist.

**8.** Quantisierer nach einem der vorhergehenden Ansprüche, **dadurch gekennzeichnet, dass** jede Verstärkerstufe ( $G_1^2 - G_{2^N-1}^2$ ) umfasst:

■ einen Differenzverstärker (72), von dem ein positiver Eingang den Eingang der Verstärkerstufe bildet;
■ eine erste Impedanz (74), die zwischen einem negativen Eingang und einem Ausgang des Differenzverstärkers (72) zwischengeschaltet ist; und
■ eine zweite Impedanz (76), die zwischen den negativen Eingang des Differenzverstärkers und Masse zwischengeschaltet ist.

**9.** Quantisierer nach einem der Ansprüche 1 bis 7, **dadurch gekennzeichnet, dass** jede Verstärkerstufe ( $G_1^2 - G_{2^N-1}^2$ ) eine Reihenschaltung aus zwei Verstärkerzellen (82, 84) umfasst, wobei sich jede dieser Zellen (82, 84) zusammensetzt aus:

■ einem Wechselrichter (820, 840), dessen Ausgang den Ausgang der Zelle (82, 84) bildet,
■ einer ersten Impedanz (822, 842), die zwischen dem Eingang und dem Ausgang des Wechselrichters (820, 840) zwischengeschaltet ist, und
■ einer zweiten Impedanz (824, 844), die mit dem einen ihrer Anschlüsse auf den Eingang des Wechselrichters (820, 840) aufgeschaltet ist, und deren anderer Anschluss den Eingang der Zelle (82, 84) bildet.

**10.** Quantisierer nach einem der Ansprüche 1 bis 7, **dadurch gekennzeichnet, dass** jede Verstärkerstufe (I1, Cs, M1) umfasst:

■ einen Wechselrichter (I1), dessen Ausgang den Ausgang der Verstärkerstufe bildet,
■ eine erste Impedanz (M1), die zwischen dem Eingang und dem Ausgang des Wechselrichters (I1) zwischengeschaltet ist, und
■ eine zweite Impedanz (Cs), die mit dem einen ihrer Anschlüsse auf den Eingang des Wechselrichters aufgeschaltet ist, und deren anderer Anschluss den Eingang der Stufe bildet.

**11.** Quantisierer nach Anspruch 5 oder 10, **dadurch gekennzeichnet, dass** er außerdem ein Modul (234) zur digitalen Verarbeitung umfasst, das ausgebildet ist, eine Funktion "ODER" auf jedes Paar von aufeinanderfolgenden Ausgängen der Verzögerungsleitungen und des letzten Komparators anzuwenden, wobei das Ergebnis der Funktion "ODER" einen quantisierten Binärwert bildet.

**12.** Quantisierer nach Anspruch 8, 9, 10 oder 11, **dadurch gekennzeichnet, dass** der stetige Wert der zweiten Impedanz (76; 824; 844; Cs) wesentlich höher ist als der stetige Wert der ersten Impedanz (74; 822; 842; M1).

**13.** Quantisierer nach Anspruch 8, 9, 10, 11 oder 12, **dadurch gekennzeichnet, dass** die erste Impedanz (M1) diejenige ist, die zwischen dem Drain und der Source eines MOS-Transistors gebildet ist.

**14.** Quantisierer nach einem der vorhergehenden Ansprüche, **dadurch gekennzeichnet, dass** der Schwellenwert für die Gesamtheit der Komparatoren ( $C_1^2 - C_{2^N-1}^2$; I2, H) eindeutig ist.

**15.** Quantisierer nach einem der vorhergehenden Ansprüche, **dadurch gekennzeichnet, dass** jeder Komparator ( $C_1^2 - C_{2^N-1}^2$ ) umfasst:

■ einen Hochverstärkungsdifferenzverstärker (92), der an einem positiven Eingang den Ausgang der entsprechenden Verstärkerstufe und an einem negativen Eingang den entsprechenden Schwellenwert empfängt, und
■ ein Binärentscheidungsfindungsmodul (94), das auf den Ausgang des Hochverstärkungsdifferenzverstärkers aufgeschaltet ist.

**16.** Quantisierer nach Anspruch 15, **dadurch gekennzeichnet, dass** das Binärentscheidungsfindungsmodul (94) einen Hysteresediskriminator (94) umfasst.

**17.** Quantisierer nach Anspruch 15 oder 16, **dadurch gekennzeichnet, dass** er außerdem ein Filtermodul (96) umfasst, das am Ausgang des Binärentscheidungsfindungsmoduls (94) angeschlossen ist, um die Impulse mit einer Dauer, die kürzer ist als eine vorbestimmte Dauer, zu beseitigen.

**18.** Quantisierer nach einem der vorhergehenden Ansprüche, **dadurch gekennzeichnet, dass** jede Verzögerungsleitung (232) $2^N$-1-i im Wesentlichen identische Verzögerungszellen umfasst, wobei i die Position der Verstärkerstufe (I1, M1, Cs) ist, die der Leitung in der Verstärkerstufenreihe zugeordnet ist.

**19.** Quantisierer nach einem der vorhergehenden Ansprüche, **dadurch gekennzeichnet, dass** er außerdem am Anfang oder am Ende der Verstärkerstufenreihe eine zusätzliche Verstärkerstufe (22) und einen zusätzliche Komparator (26) umfasst, der auf den Ausgang der zusätzlichen Verstärkerstufe (22) aufgeschaltet ist und ausgebildet ist, deren Ausgang mit dem Nullwert zu vergleichen, um das Vorzeichen des zu quantisierenden Signals zu bestimmen.

**20.** N-Bit-Analog/Digital-Wandler (150), der einen Quantisierer (1500) nach einem der vorhergehenden Ansprüche und einen Abtaster (1502) umfasst, der mit dem Quantisierer verbunden ist und ausgebildet ist, die Signale abzutasten, die er am Eingang empfängt.

**21.** Analog/Digital-Wandler nach Anspruch 20, **dadurch gekennzeichnet, dass** er ein Modul (1504) zur digitalen Verarbeitung umfasst, das zwischen dem Quantisierer (1500) und dem Abtaster (1502) zwischengeschaltet ist.

**22.** Funkfrequenzempfänger (160) der Art, die einen Wandler (1604, 1606, 1608) nach einem der Ansprüche 20 oder 21 integriert hat.

**23.** Funkfrequenzempfänger nach Anspruch 22, **dadurch gekennzeichnet, dass** der Quantisierer eine Quantisierung mit logarithmischer Komprimierung einsetzt.

**24.** Funkfrequenzempfänger nach Anspruch 22 oder 23, **dadurch gekennzeichnet, dass** er ausgebildet ist, Funkfrequenzsignale mit modulierter Trägerwelle zu empfangen.

**25.** Funkfrequenzempfänger nach Anspruch 22 oder 23, **dadurch gekennzeichnet, dass** er ausgebildet ist, Ultrabreitband-Funkfrequenzsignale zu empfangen.

10
Vref
Vin
G1
H
G
Vcomp
C11
V1
Q1
R11
C21
V2
Q2
R21
V3
Q3
C31
R3
V2N-1
Q2N-1
C12N-1

(Etat de la technique)

**Fig. 1**

20
E21
E22
E23
G22
G23
G22N-1
E22N-1
22
24
Vin
G1
G2
G3
G2N-1
G'
G21
Vth
0
C21
C22
C32
C22N-1
26
D1
D2
D3
D2N-1
D21
D22
D23
D22N-1
Q1
Q2
Q3
Q2N-1
Signe
Amplitude quantifiée

**Fig. 2**

Fig. 3
GV_in
V4
V3
V2
V1
Fig. 5
4G1 Vin
3G1 Vin
2G1 Vin
G1 Vin
Vin
Fig. 4
Q1
Q2
Q3
Q4
Fig. 6
Fig. 7
E
70
72
S
A
+
-
Z1
74
76
Z2
Fig. 8
80
82
84
E
820
840
S
Z2
-A
Z1
824
822
844
842

90
E
Vth
92
A
94
96
962
966
960
964
968
S

Fig. 9

100
E
R2
102
104
S
108
R1
106

Fig. 10

S
+V
E
-R1xV
R2
+R1xV
R2
-V

Fig. 11

120
1220
1240
Vcom
124
1222
122
1242
E
S
1244
1224

Fig. 12

130
1320
134
Vcom
1322
132
1342
E
S
1344
1324

Fig. 13

1404
1406
S
E
1400
1402
140
I com
1408


Fig. 14

150
1500
1504
1502
Vin
Quantificateur
Traitements numériques asynchrones
Echantillonnage
Signaux contribuant au traitement
Horloge H


Fig. 15

160
1600
1602
1604
1606
1608
1610
RFin
G
Amplificateur faible bruit
Quantificateur logarithmique
Redresseur + Filtre passe-bas
Bascules D
Encodage de thermométrique vers binaire
Horloge d'échantillonnage


Fig. 16

Entrée RF
Ampli LNA
Quantification
Redressement
Filtrage passe-bas
Echantillonnage
15
10
5
0
-5
-10
-15
-2,0E-09 -1,5E-09 -1,0E-09 -5,0E-10 0,0E+00 5,0E-10 1,0E-09 1,5E-09 2,0E-09

Fig. 17

Fig. 18

Fig. 19

Fig. 20

Fig. 21

Fig. 22

Fig. 23
230
$V_{gain}$
$V_{in}$
$C_S$
M1
I1
I2
$E_1^{23}$
$E_2^{23}$
$E_{2^N-1}^{23}$
$H_\Delta$
Cellules de quantification
Cellules de compensation de retard
232
τ
δ
2344
2342
2340
234
Filtre
Horloge d'échantillonnage
Bascules d'échantillonnage
236

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Documents brevets cités dans la description

- US S760730 A
- WO 2005074150 A